# FASCICULE DE BREVET EUROPEEN

(11) **EP 3 190 335 B1**
(45) Date de publication et mention de la délivrance du brevet: **05.12.2018**
(21) Numéro de dépôt: 17150337.8
(22) Date de dépôt: 05.01.2017
(51) Int. Cl.: H01S 5/00, F21S 41/00

(54) **DISPOSITIF LUMINEUX MUNI D'UN ÉLÉMENT DE CONVERSION DE LONGUEUR D'ONDE COURBE, ET PROJECTEUR COMPRENANT UN TEL DISPOSITIF LUMINEUX**
LEUCHTVORRICHTUNG, DIE MIT EINEM GEKRÜMMTEN UMWANDLUNGSELEMENT DER WELLENLÄNGE AUSGESTATTET IST, UND SCHEINWERFER, DER EINE SOLCHE LEUCHTVORRICHTUNG UMFASST
LUMINOUS DEVICE PROVIDED WITH A CURVED WAVELENGTH CONVERSION ELEMENT, AND HEADLIGHT COMPRISING SUCH A LUMINOUS DEVICE

(30) Priorité: 11.01.2016 FR 1650203
(43) Date de publication de la demande: 12.07.2017
(73) Titulaire: Valeo Vision, 93012 Bobigny Cedex (FR)
(72) Inventeur: BOINET, Loic, 76240 LE MESNIL ESNARD (FR)

(56) Documents cités:
- DE-A1-102010 028 949
- US-A1- 2015 167 934

## Description

La présente invention concerne un dispositif lumineux muni d'un élément de conversion de longueur d'onde courbe, notamment pour véhicule automobile, et un système d'éclairage et/ou de signalisation muni d'un tel dispositif lumineux.

Les projecteurs de véhicule automobile sont munis d'un ou de plusieurs modules optiques agencés dans un boîtier fermé par une glace de manière à obtenir un ou plusieurs faisceaux lumineux à la sortie du projecteur. De façon simplifiée, un module optique du boîtier comprend notamment une source de lumière, par exemple une (ou plusieurs) diode(s) électroluminescente(s), qui émet des rayons lumineux, et un système optique comportant une ou plusieurs lentilles et, le cas échéant un élément optique, par exemple un réflecteur, pour orienter les rayons lumineux issus des sources lumineuses, afin de former le faisceau lumineux de sortie du module optique.

En outre, on peut utiliser d'autres technologies pour ces dispositifs. Ainsi, il existe des diodes lasers qui peuvent avantageusement remplacer les diodes électroluminescentes. Cependant, les lasers usuels sont d'une couleur qui ne correspond pas aux couleurs réglementaires de tels projecteurs. Le module comporte alors un élément de conversion de longueur d'ondes, qui reçoit le faisceau lumineux de la source laser et qui le réémet en lumière blanche vers un système optique de projection et forme ainsi une partie du faisceau d'éclairage du projecteur.

Pour illuminer une zone plus large de l'élément de conversion avec un faisceau lumineux, des moyens de balayage du faisceau lumineux sont nécessaires. Le balayage est effectué à une fréquence suffisamment importante pour que l'oeil humain ne perçoive pas le mouvement et voit un éclairage continu du faisceau sortant du module.

Les moyens de balayage connus sont par exemple des éléments de type MEMS (pour « Micro-Electro-Mechanical-Systems » en anglais ou microsystèmes électromécaniques), comprenant un ou des micro-miroirs qui réfléchissent le faisceau laser sur la zone. Ces micro-miroirs sont par exemple animés d'au moins un mouvement rotatif autour d'un axe qui engendre le balayage de la zone selon une première direction. Un second micro-miroir ou un autre mouvement rotatif du premier miroir autour d'un second axe perpendiculaire au premier axe permet de produire un balayage selon deux directions. Le faisceau laser balaye par conséquent la zone.

Le balayage du faisceau s'effectue d'un bord à l'autre de la zone illuminée de l'élément de conversion. Cependant, le balayage ne peut avoir une vitesse constante sur toute la largeur de la zone. En effet, le balayage doit s'arrêter à chaque bord de la zone pour repartir dans un autre sens vers l'autre bord. Par conséquent, l'éclairage réémis par l'élément de conversion n'est pas uniforme, l'éclairage du bord de la zone illuminée étant plus intense que celui du centre. Or, on souhaite plutôt avoir un faisceau dont le centre est plus lumineux que sur les côtés, pour répondre aux réglementations en vigueur.

L'invention vise donc à obtenir un dispositif lumineux qui améliore la situation et évite les défauts précités, afin notamment d'obtenir un éclairage plus uniforme. DE 10.2010.028.949 divulgue un dispositif selon le préambule de la revendication 1.

Pour cela, l'invention concerne un dispositif lumineux, notamment pour véhicule automobile, comprenant au moins une source de lumière apte à émettre des rayons lumineux pour former un faisceau lumineux et un système optique de projection configuré pour transmettre le faisceau lumineux selon un axe optique.

Le dispositif est remarquable en ce qu'il comporte en outre un élément de conversion de longueur d'onde configuré pour recevoir les rayons lumineux émis par la source de lumière et pour réémettre un rayonnement lumineux générant ledit faisceau lumineux en direction du système optique de projection, et des moyens de balayage configurés pour opérer un balayage des rayons lumineux émis par la source de lumière sur l'élément de conversion, l'élément de conversion présentant une courbure convexe vers les moyens de balayage. L'élément de conversion est sensiblement cylindrique.

Ainsi, la courbure de l'élément de conversion accentue la différence de distance entre la source du faisceau lumineux et les différentes parties de l'élément de conversion. Autrement dit, la partie de la surface la plus convexe de l'élément de conversion est plus proche de la source que les autres parties de la surface. Cette différence de distance induit une différence d'intensité reçue sur l'élément de conversion et transmise par ce dernier. Grâce à un tel élément de conversion, on peut compenser le manque d'intensité lumineuse au centre par rapport aux côtés du faisceau transmis par l'élément de conversion. On obtient de la sorte un faisceau qui est plus homogène, voire qui augmente l'intensité lumineuse au centre par rapport aux côtés.

Selon différents modes de réalisation de l'invention, qui pourront être pris ensemble ou séparément :
- les moyens de balayage sont configurés pour faire balayer les rayons lumineux émis par la source de lumière selon une première direction,
- la forme cylindrique est définie par une courbe directrice et une droite génératrice,
- les moyens de balayage sont configurés pour faire balayer les rayons lumineux sur l'élément de conversion selon une direction sensiblement orthogonale à la droite génératrice,
- l'élément de conversion est configuré pour que la longueur d'onde du rayonnement lumineux réémis soit distincte de celle des rayons lumineux reçus afin d'obtenir une couleur souhaitée,
- la couleur souhaitée est par exemple une lumière blanche.
- les moyens de balayage sont configurés pour faire balayer les rayons lumineux selon une deuxième direction,
- les moyens de balayage sont munis d'un micro-miroir mobile configuré pour réfléchir les rayons lumineux émis par la source de lumière de sorte à balayer l'élément de conversion selon la première direction et/ou selon la deuxième direction,
- le même micro-miroir fait balayer la surface de l'élément de conversion par les rayons lumineux selon les deux directions,
- les moyens de balayage sont munis de deux micro-miroirs configurés pour faire balayer les rayons lumineux respectivement selon la première direction et selon la deuxième direction,
- les moyens de balayage sont agencés dans l'axe optique du système de projection,
- le ou les micro-miroirs sont animés d'un mouvement périodique produit par un actionneur,
- l'élément de conversion est agencé dans l'axe optique du système optique de projection,
- le système optique de projection est configuré pour un élément de conversion courbe,
- le système de projection présente une courbure de champ correspondant sensiblement à la courbure de l'élément de conversion,
- l'élément de conversion comprend un substrat et une couche d'un matériau photoluminescent,
- le substrat est transparent,
- le matériau photoluminescent contient par exemple du phosphore, ou du grenat d'yttrium et d'aluminium,
- la source de lumière comporte au moins une diode laser.

L'invention se rapporte également à un système d'éclairage et/ou de signalisation de véhicule automobile comprenant un tel dispositif lumineux. Le système comprend, de préférence, un moyen d'alimentation électrique de la source de lumière configuré pour que la source de lumière émette des rayons lumineux dont l'intensité lumineuse est constante lorsqu'elle est alimentée.

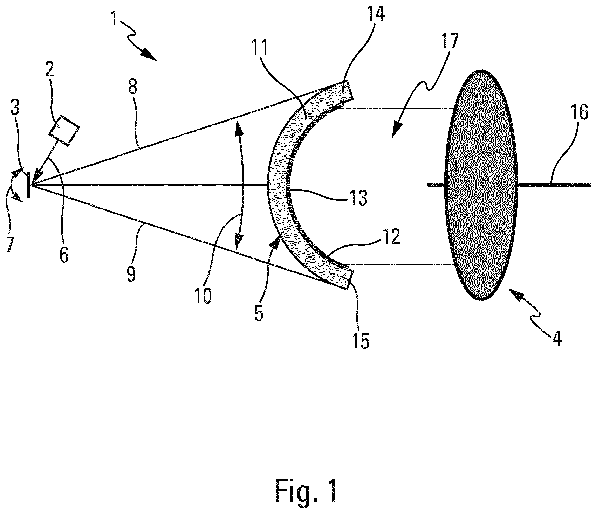

L'invention sera mieux comprise à la lumière de la description suivante qui n'est donnée qu'à titre indicatif et qui n'a pas pour but de la limiter, accompagnée de la figure 1 illustrant de façon schématique, une vue en coupe de profil d'un mode de réalisation d'un dispositif lumineux selon l'invention.

La figure 1 représente un dispositif lumineux 1 selon un mode de réalisation de l'invention, notamment pour un système d'éclairage et/ou de signalisation de véhicule automobile, comprenant au moins une source de lumière 2 apte à émettre des rayons lumineux pour former un faisceau lumineux 6. Ici, la source de lumière 2 est par exemple une ou plusieurs diodes laser. La source de lumière 2 peut aussi comprendre un dispositif optique combinant en un seul faisceau plusieurs rayonnements lasers, par exemple à l'aide de fibres optiques ou de dispositifs tirant profit des polarisations différentes de différentes sources laser. Le système comprend, de préférence, un moyen d'alimentation électrique de la source de lumière 2 configuré pour que la source de lumière 2 émette des rayons lumineux 6 dont l'intensité lumineuse est constante lorsqu'elle est alimentée.

Le dispositif 1 comporte un élément de conversion 5 de longueur d'onde configuré pour recevoir des rayons lumineux de la source de lumière 2 et réémettre d'autres rayons lumineux dont la longueur d'onde est distincte de celle des rayons lumineux reçus. L'élément de conversion 5 permet par exemple d'obtenir une couleur souhaitée pour l'éclairage du projecteur, par exemple une lumière blanche à partir de rayons lumineux bleus. L'élément de conversion 5 comprend ici un substrat transparent 11 et une couche 12 d'un matériau photoluminescent, par exemple à base de phosphore ou de grenat d'yttrium et d'aluminium (connu sous le sigle YaG). Ainsi, l'élément de conversion 5 convertit des rayons lumineux 6 émis par la source de lumière en un faisceau lumineux 17 de couleur différente de celle des rayons. L'élément de conversion 5 peut, selon le cas, convertir une partie seulement ou la plupart des rayons lumineux émis par la source 2 pour former le faisceau lumineux 17.

Le dispositif 1 est muni d'un système optique de projection 4 qui sert à collimater le faisceau lumineux 17 issus de l'élément de conversion et le transmettre en un faisceau d'éclairage selon un axe optique 16 vers l'extérieur du dispositif 1. Pour cela, le système optique de projection 4 est sensiblement agencé dans l'axe optique de l'élément de conversion 5.

Le dispositif 1 est en outre pourvu de moyens de balayage 3 agencés dans l'axe de l'élément de conversion 5, du côté opposé par rapport au système optique de projection 4. Les moyens de balayage 3 reçoivent les rayons lumineux 6 de la source 2 et les renvoient vers l'élément de conversion 5. Ainsi, l'élément de conversion 5 est positionné entre les moyens de balayage 3 et le système optique de projection 4, le faisceau lumineux 17 étant réémis par l'élément de conversion 5. Les moyens de balayage sont configurés pour opérer un balayage du faisceau lumineux 6 sur l'élément de conversion 5. Le balayage est effectué à une vitesse suffisamment élevée pour que l'oeil n'aperçoive pas le balayage et que l'élément de conversion transmette un faisceau d'éclairage sensiblement continu pour l'oeil. Comme illustré par la flèche 10 sur la figure 1, les rayons 6 balayent l'élément de conversion 5 entre deux positions 8 et 9 extrêmes. Les deux positions 8 et 9 sont choisies de préférence pour illuminer les extrémités 14, 15 de l'élément de conversion 5, et ainsi couvrir sensiblement toute la surface de l'élément de conversion 5.

Dans une première variante de réalisation, les moyens de balayage 3 sont par exemple munis d'un micro-miroir mobile permettant de balayer l'élément de conversion 5 par réflexion des rayons lumineux 6 vers l'élément de conversion 5. Le balayage est effectué selon une première direction de la surface de l'élément de conversion 5, qui est par exemple verticale. Le micro-miroir est animé d'un mouvement périodique produit par un actionneur (non représenté), qui utilise par exemple un effet de résonnance du micro-miroir provoqué, par exemple, par des électrodes pour le faire osciller. Le mouvement du micro-miroir, représenté par la flèche 7, est opéré autour d'un axe de rotation orthogonal à la première direction afin que les rayons lumineux 6 balayent la surface de l'élément de conversion 3 selon ladite première direction.

Dans une deuxième variante de réalisation, les moyens de balayage 4 sont également configurés pour balayer l'élément de conversion 3 avec les rayons lumineux 6 selon une deuxième direction. La deuxième direction est de préférence sensiblement perpendiculaire à la première direction afin de produire un mouvement des rayons 6qui se déplace aisément sur l'élément de conversion 5.

Autrement dit, c'est le même micro-miroir qui balaye la surface de l'élément de conversion 5 avec les rayons lumineux 6 selon les deux directions. Le micro-miroir suit donc un autre mouvement, par exemple de rotation autour d'un deuxième axe de rotation perpendiculaire au précédent. Ainsi, le micro-miroir permet de balayer à la fois horizontalement et verticalement l'élément de conversion 5.

Une troisième variante de réalisation, non représentée sur les figures, consiste à utiliser un deuxième micro-miroir pour faire balayer les rayons lumineux selon la deuxième direction. Dans ce cas, les moyens de balayage sont munis de deux micro-miroirs disposés l'un à la suite de l'autre sur le chemin optique du faisceau, chacun ayant pour fonction de faire balayer l'élément de conversion par les rayons lumineux, chacun selon l'une des deux directions.

Dans la description, les micro-miroirs mentionnés comme moyen de balayage sont par exemple de type MEMS (pour « Micro-Electro-Mechanical Systems » en anglais ou microsystèmes électromécaniques). Cependant, l'invention n'est nullement limitée à ce moyen de balayage et peut utiliser d'autres sortes de moyens de balayage comme par exemple une série de miroirs agencés sur un élément rotatif, la rotation de l'élément engendrant un balayage de l'élément de conversion par le faisceau lumineux.

Selon l'invention, l'élément de conversion 5 présente une courbure convexe vers les moyens de balayage 3. Ainsi, la partie centrale 13 de l'élément de conversion 5 est plus proche des moyens de balayage 3, et les extrémités 14, 15 sont plus éloignées. Ainsi, la partie centrale 13 transmet une intensité lumineuse plus importante des rayons lumineux 6 que les extrémités 14, 15. Ainsi, le faisceau lumineux 17 réémis par l'élément de conversion 5 est plus intense au milieu que sur les côtés.

En outre, le système optique de projection 4 est configuré pour un élément de conversion 5 courbe afin d'obtenir un faisceau d'éclairage plus homogène. Le système de projection présente par exemple une courbure de champ correspondant sensiblement à la courbure de l'élément de conversion. Pour cela, il peut comprendre une pluralité de lentilles.

Dans un premier mode de réalisation, l'élément de conversion 5 est sensiblement cylindrique, la forme cylindrique étant définie par une courbe directrice et une droite génératrice. Les moyens de balayage sont de préférence configurés pour faire balayer les rayons lumineux 6 sur l'élément de conversion 5 selon une direction sensiblement orthogonale à la droite génératrice. Ainsi, les extrémités 14, 15 éloignées de l'élément de conversion 5 correspondent sensiblement aux deux positions 8, 9 extrêmes de balayage des rayons lumineux 6. On utilise donc de préférence des moyens de balayage 3 à une seule dimension.

Dans un deuxième mode de réalisation, non revendiqué, l'élément de conversion 5 est sensiblement de forme parabolique, ou sphérique. Ici, les moyens de balayage 3 impriment de préférence aux rayons lumineux 6 un balayage selon deux dimensions. En effet, à deux dimensions, les rayons 6 balayent selon deux directions, et ont donc deux paires de positions, telles que 8 et 9, du faisceau lumineux 6, une paire par direction de balayage. Une telle forme de l'élément de conversion 5 permet d'avoir des extrémités 14, 15 éloignées de l'élément de conversion 5 pour les deux paires de position.

## Revendications

1. Dispositif lumineux (1), notamment pour véhicule automobile, comprenant au moins une source de lumière (2) apte à émettre des rayons lumineux (6) pour former un faisceau lumineux (17) et un système optique de projection (4) configuré pour projeter le faisceau lumineux (17) selon un axe optique (16), le dispositif lumineux comportant en outre un élément de conversion (5) de longueur d'onde configuré pour recevoir les rayons lumineux (6) émis par la source de lumière (2) et pour réémettre un rayonnement lumineux générant ledit faisceau lumineux (17) en direction du système optique de projection (4), et des moyens de balayage (3) configurés pour opérer un balayage des rayons lumineux (6) émis par la source de lumière (2) sur l'élément de conversion (5), l'élément de conversion (5) présentant une courbure convexe vers les moyens de balayage (3) **caractérisé en ce que** l'élément de conversion est sensiblement cylindrique.

2. Dispositif selon la revendication 1, **caractérisé en ce que** les moyens de balayage (3) sont configurés pour faire balayer les rayons lumineux (6) émis par la source de lumière selon au moins une première direction.

3. Dispositif selon la revendication 2, **caractérisé en ce que** les moyens de balayage (3) sont configurés pour faire balayer les rayons lumineux (6) selon une deuxième direction.

4. Dispositif selon l'une quelconque des revendications 2 à 3, **caractérisé en ce que** les moyens de balayage (3) sont munis d'un micro-miroir mobile configuré pour réfléchir les rayons lumineux (6) émis par la source de lumière de sorte à balayer l'élément de conversion (5) selon la première direction et/ou selon la deuxième direction.

5. Dispositif selon la revendication 3, **caractérisé en ce que** les moyens de balayage (3) sont munis de deux micro-miroirs configurés pour faire balayer les rayons lumineux (6) respectivement selon la première direction et selon la deuxième direction.

6. Dispositif selon l'une quelconque des revendications précédentes, **caractérisé en ce que** les moyens de balayage (3) sont agencés sensiblement dans l'axe optique du système de projection (4).

7. Dispositif selon l'une quelconque des revendications précédentes, **caractérisé en ce que** l'élément de conversion (5) est agencé sensiblement dans l'axe optique (16) du système de projection (4).

8. Dispositif selon l'une quelconque des revendications précédentes, **caractérisé en ce que** le système optique de projection (4) est configuré pour un élément de conversion (5) courbe.

9. Dispositif selon l'une quelconque des revendications précédentes, **caractérisé en ce que** l'élément de conversion (5) comprend un substrat (11) et une couche d'un matériau photoluminescent (12).

10. Dispositif selon l'une quelconque des revendications précédentes, **caractérisé en ce que** la source de lumière (2) comporte au moins une diode laser.

11. Système d'éclairage et/ou de signalisation de véhicule automobile comprenant un dispositif lumineux (1) selon l'une quelconque des revendications précédentes.

12. Système selon la revendication précédente, comprenant un moyen d'alimentation électrique de la source de lumière configuré pour que la source de lumière émette des rayons lumineux dont l'intensité lumineuse est constante lorsqu'elle est alimentée.

## Patentansprüche

1. Leuchtvorrichtung (1), insbesondere für ein Kraftfahrzeug, die mindestens eine Lichtquelle (2), die Lichtstrahlen (6) emittieren kann, um ein Lichtbündel (17) zu bilden, und ein optisches Projektionssystem (4) enthält, das konfiguriert ist, das Lichtbündel (17) gemäß einer optischen Achse (16) zu projizieren, wobei die Leuchtvorrichtung außerdem ein Wellenlängen-Umwandlungselement (5) aufweist, das konfiguriert ist, die von der Lichtquelle (2) emittierten Lichtstrahlen (6) zu empfangen und eine Lichtstrahlung zu reemittieren, die das Lichtbündel (17) in Richtung des optischen Projektionssystems (4) erzeugt, und Abtasteinrichtungen (3) aufweist, die konfiguriert sind, ein Abtasten der von der Lichtquelle (2) emittierten Lichtstrahlen (6) auf dem Umwandlungselement (5) durchzuführen, wobei das Umwandlungselement (5) eine konvexe Krümmung zu den Abtasteinrichtungen (3) aufweist, **dadurch gekennzeichnet, dass** das Umwandlungselement im Wesentlichen zylindrisch ist.

2. Vorrichtung nach Anspruch 1, **dadurch gekennzeichnet, dass** die Abtasteinrichtungen (3) konfiguriert sind, die von der Lichtquelle emittierten Lichtstrahlen (6) gemäß mindestens einer ersten Richtung abtasten zu lassen.

3. Vorrichtung nach Anspruch 2, **dadurch gekennzeichnet, dass** die Abtasteinrichtungen (3) konfiguriert sind, die Lichtstrahlen (6) gemäß einer zweiten Richtung abtasten zu lassen.

4. Vorrichtung nach einem der Ansprüche 2 bis 3, **dadurch gekennzeichnet, dass** die Abtasteinrichtungen (3) mit einem beweglichen Mikrospiegel versehen sind, der konfiguriert ist, die von der Lichtquelle emittierten Lichtstrahlen (6) zu reflektieren, um das Umwandlungselement (5) gemäß der ersten Richtung und/oder der zweiten Richtung abzutasten.

5. Vorrichtung nach Anspruch 3, **dadurch gekennzeichnet, dass** die Abtasteinrichtungen (3) mit zwei Mikrospiegeln versehen sind, die konfiguriert sind, die Lichtstrahlen (6) gemäß der ersten Richtung bzw. gemäß der zweiten Richtung abtasten zu lassen.

6. Vorrichtung nach einem der vorhergehenden Ansprüche, **dadurch gekennzeichnet, dass** die Abtasteinrichtungen (3) im Wesentlichen in der optischen Achse des Projektionssystems (4) angeordnet sind.

7. Vorrichtung nach einem der vorhergehenden Ansprüche, **dadurch gekennzeichnet, dass** das Umwandlungselement (5) im Wesentlichen in der optischen Achse (16) des Projektionssystems (4) angeordnet ist.

8. Vorrichtung nach einem der vorhergehenden Ansprüche, **dadurch gekennzeichnet, dass** das optische Projektionssystem (4) für ein gekrümmtes Umwandlungselement (5) konfiguriert ist.

9. Vorrichtung nach einem der vorhergehenden Ansprüche, **dadurch gekennzeichnet, dass** das Umwandlungselement (5) ein Substrat (11) und eine Schicht eines photolumineszierenden Materials (12) aufweist.

10. Vorrichtung nach einem der vorhergehenden Ansprüche, **dadurch gekennzeichnet, dass** die Lichtquelle (2) mindestens eine Laserdiode aufweist.

11. Beleuchtungs- und/oder Signalisierungssystem eines Kraftfahrzeugs, das eine Leuchtvorrichtung (1) nach einem der vorhergehenden Ansprüche enthält.

12. System nach dem vorhergehenden Anspruch, das eine Stromversorgungseinrichtung der Lichtquelle enthält, die so konfiguriert ist, dass die Lichtquelle Lichtstrahlen emittiert, deren Lichtstärke konstant ist, wenn sie versorgt wird.

## Claims

1. Lighting device (1), in particular for an automotive vehicle, comprising at least one light source (2) capable of emitting light rays (6) to form a light beam (17) and an optical projection system (4) configured to project the light beam (17) along an optical axis (16), the lighting device additionally comprising a wavelength conversion element (5) configured to receive the light rays (6) emitted by the light source (2) and to re-emit light radiation creating said light beam (17) in the direction of the optical projection system (4), and scanning means (3) configured to scan the light rays (6) emitted by the light source (2) over the conversion element (5), the conversion element (5) being convexly curved toward the scanning means (3), **characterized in that** the conversion element (5) is substantially cylindrical.

2. Device according to Claim 1, **characterized in that** the scanning means (3) are configured to make the light rays (6) emitted by the light source scan in at least a first direction.

3. Device according to Claim 2, **characterized in that** the scanning means (3) are configured to make the light rays (6) scan in a second direction.

4. Device according to any one of Claims 2 to 3, **characterized in that** the scanning means (3) are equipped with a movable micromirror configured to reflect the light rays (6) emitted by the light source so as to scan the conversion element (5) in a first direction and/or in a second direction.

5. Device according to Claim 3, **characterized in that** the scanning means (3) are equipped with two micromirrors configured to make the light rays (6) scan in the first direction and in the second direction, respectively.

6. Device according to any one of the preceding claims, **characterized in that** the scanning means (3) are arranged substantially on the optical axis of the projection system (4).

7. Device according to any one of the preceding claims, **characterized in that** the conversion element (5) is arranged substantially on the optical axis (16) of the projection system (4).

8. Device according to any one of the preceding claims, **characterized in that** the optical projection system (4) is configured for a curved conversion element (5).

9. Device according to any one of the preceding claims, **characterized in that** the conversion element (5) comprises a substrate (11) and a layer of a photoluminescent material (12).

10. Device according to any one of the preceding claims, **characterized in that** the light source (2) comprises at least one laser diode.

11. Lighting and/or signaling system for an automotive vehicle, comprising a lighting device (1) according to any one of the preceding claims.

12. System according to the preceding claim, comprising a means for supplying electrical power to the light source, configured so that the light source emits light rays whose luminous intensity is constant when it is supplied with power.
